(19) Europäisches Patentamt

European Patent Office

Office européen des brevets

(11) **EP 1 375 691 A1**

(12) **EUROPEAN PATENT APPLICATION**
published in accordance with Art. 158(3) EPC

(43) Date of publication:
**02.01.2004 Bulletin 2004/01**

(21) Application number: **02705498.0**

(22) Date of filing: **26.03.2002**

(51) Int Cl.[7]: **C22C 21/06**, C22C 21/02,
C22F 1/05

(86) International application number:
**PCT/JP2002/002900**

(87) International publication number:
**WO 2002/079533 (10.10.2002 Gazette 2002/41)**

(84) Designated Contracting States:
**AT BE CH CY DE DK ES FI FR GB GR IE IT LI LU
MC NL PT SE TR**

(30) Priority: 28.03.2001 JP 2001091979
28.03.2001 JP 2001091980
27.09.2001 JP 2001295633
08.03.2002 JP 2002063118
08.03.2002 JP 2002063119
20.03.2002 JP 2002077794
20.03.2002 JP 2002077795

(71) Applicant: **SUMITOMO LIGHT METAL
INDUSTRIES, LTD.
Tokyo105-8601 (JP)**

(72) Inventors:
• **UCHIDA, Hidetoshi,
c/o Sumitomo Lt. Metal Ind. Ltd
Tokyo 105-8601 (JP)**

• **MINODA, Tadashi,
c/o Sumitomo Light Metal Ind. Ltd
Tokyo 105-8601 (JP)**
• **ASANO, Mineo,
c/o Sumitomo Light Metal Ind. Ltd.
Tokyo 105-8601 (JP)**
• **OZEKI, Yoshikazu,
c/o Sumitomo Light Metal Ind Ltd
Tokyo 105-8601 (JP)**
• **FURUYAMA, Tsutomu,
c/o Sumitomo Lt. Metal Ind. Ltd
Tokyo 105-8601 (JP)**

(74) Representative: **Marx, Lothar, Dr.
Patentanwälte Schwabe, Sandmair, Marx
Stuntzstrasse 16
81677 München (DE)**

(54) **ALUMINUM ALLOY SHEET EXCELLENT IN FORMABILITY AND HARDENABILITY DURING
BAKING OF COATING AND METHOD FOR PRODUCTION THEREOF**

(57)    The present invention relates to an ultra-thin metal film, an ultra-thin metal multilayer film, and a method of fabricating an ultra-thin metal film or an ultra-thin metal multilayer film. The ultra-thin metal film and the ultra-thin metal multilayer film can be obtained by forming a dielectric film on a conductive base material in a film thickness that causes the significant tunneling effect between metals through the thin dielectric film, or a film thickness whereby the valence electrons and holes of the metal composing the metallic base material and the ultra-thin metal film are affected by the many-body effects, for example, in a film thickness wherein the bandgap width of said dielectric is narrowed; and the ultra-thin metal films are formed on the dielectric grown in the layer-by-layer mode by the deposition method. According to the present invention, an ultra-thin metal film or a film wherein ultra-thin metal films are multilayered can be obtained without forming clusters, and the present invention can be applied for the extension of the life of catalysts, the densification of integrated circuits and the like.

EP 1 375 691 A1

## Description

Technical Field

The present invention relates to an ultra-thin metal film, an ultra-thin metal multilayer film, and a method of fabricating an ultra-thin metal film or an ultra-thin metal multilayer film.

Background Art

It is a well-known phenomenon that a transition metal grows in an island shape when it is deposited on the surface of a single-crystal oxide (Vollmer-Weber mode).

Japanese Patent Laid-Open No. 62-87820 discloses, as a sample for infrared absorption analysis, what is deposited Pt (platinum) as a first thin film partially transmitting infrared beams is deposited on one low-index surface of a single-crystal silicon substrate, and then a second thin film to be the sample is deposited on the first thin film (Pt).

This sample for infrared absorption analysis has an enhanced reliability of information such as molecular orientation by making the thickness of the first thin film (Pt) to a thickness partially transmitting infrared beams so that the same sample can be used for both measurement methods of the transmission method and the reflection method.

In the description, as specific thickness of the above-described first thin film (Pt), a thickness of 50 to 200 angstroms is described, and in the example, a thin Pt film of 100 angstroms is formed.

As described above, when a transition metal such as Pt is deposited on the surface of a single-crystal oxide, Pt is first deposited in an island shape on the single-crystal oxide (hereafter, this deposit is referred to as cluster), and the cluster is gradually densified to be a continuous film (thin film).

Since a Pt cluster is an aggregation of Pt atoms, and has a diameter of about 30 nm (300 angstroms) and a thickness of 6 to 8 nm (60 to 80 angstroms), films thinner than this cannot be formed. The description of the above-described patent also supports this fact.

Disclosure of the Invention

The object of the present invention is to obtain an ultra-thin metal film that has neither been obtained naturally nor artificially.

If an ultra-thin film of a metal, such as Pt, Pd, Ni, Ti, Au, Ag, Cu, Al and Zn, can be formed on an insulator, not only the quantities of the metals used as catalysts can be reduced, but also the mechanism of the activity of catalysts, or the mechanism of photochemical reactions can be clarified by electron transition.

The ultra-thin metal film according to the present invention has a structure wherein one atom in thickness forms a two-dimensionally continuous film, and the thickness thereof is 3 nm or less, and specifically bout 0.2 nm.

The present inventor obtained findings that when the film thickness of a thin film of a dielectric (insulator) is made extremely thin on the metal, the tunneling effect between metals present sandwiching the thin dielectric film occurred easily, and that the valence electrons and holes of the both metals were interacted by the many-body effects.

Specifically, the present inventor verified that the band gap of $\alpha$-$AL_2O_3$ (corundum) narrowed using the electron energy loss spectrum (EELS). Namely, the band gap when the thickness was 3 nm was about 9 eV, while the band gap when the thickness was 1 nm was about 3 eV.

In this connection, although Frederick et al. reported the formation of $\alpha$-$AL_2O_3$ (corundum) on a substrate (Ru) in Surface Science, 244 (1991), the paper did not discuss the effect of the tunneling effect between metals and the many-body effects, and no findings on the band gap narrowing of $\alpha$-$AL_2O_3$ (corundum) were reported.

The phenomenon that the band gap is narrowed when the film thickness of the above-described thin dielectric film is extremely thinned was unpredictable. The present inventor considered that the reason is the many-body effects such as the narrowing of the band gap due to a mirror-image charge, or the tailing effect on the wave function from the substrate (Ru) to the thin oxide film ($\alpha$-$AL_2O_3$).

The present inventor reached the conclusion that if the above-described hypothesis is correct, the energy stabilization caused by the delocalization of electrons (delocalization) overcomes the aggregating force of metal atoms to form no clusters, and an extremely thin metal film can be prepared.

Actually, when $\alpha$-$Al_2O_3$ (corundum) of a thickness of about 1 nm is formed on an Ru (ruthenium) substrate, and when Pt is vapor-deposited on the $\alpha$-$Al_2O_3$ (corundum), an ultra-thin Pt film (monoatomic layered film) is obtained.

Similarly, when $SiO_2$ (considered to be $\beta$-quartz) of a thickness of about 3 nm is formed on an Ni (nickel) substrate, and when Pt is vapor-deposited on the $SiO_2$, an ultra-thin Pt film (5-atom multilayered film) is obtained.

In the present invention, as conductive base materials that exhibit metallic conduction, Ru as well as metals such as Ni, Mo, Ta, Ag and Co, and graphite can be considered; and the conductive base materials that exhibit metallic conduction include those formed on a silicon, ceramic or glass substrate.

As dielectrics (insulators), $Al_2O_3$ as well as $SiO_2$, MgO and AlN can be considered; and single crystals, or oriented polycrystals regularly oriented that exhibit tensor characteristics as in single crystals are preferable. In the examples, the reason why Ru is selected as the conductive materials, and $Al_2O_3$ is selected as the dielectrics is that these have lattice constants close to each other.

As metals composing an ultra-thin metal film formed on a dielectric, metals such as Pt (platinum), Pd (palladium), Ni (nickel), Ti (titanium), Au (gold), Ag (silver), Cu (copper), Al (aluminum), Zn (zinc), Co (cobalt), Mn (manganese), Mo (molybdenum), W (tungsten), Re (rhenium), Ru (ruthenium) and Rh (rhodium); or various alloys such as a Pt-Ru system, a Pt-Pd system, a Pt-Rh system, a Pt-Ni system, a Pt-Cr system, a Pt-Co system, a Pt-Mo system, a Pt-Fe system, an Ni-Mo system, an Ni-Co system, an Ni-Mo-Co system, an Mo-Co system, an Fe-Cr system, a Cu-Zn system, a Cu-Cr system, a Cu-Ni system, a Zn-Cr system, a Zn-Al system, a Cd-Cu system and Cd-Zn system can be considered.

In order to thin the thickness of the thin dielectric (insulator) film to the degree wherein the tunneling effect or the many-body effects occurs, or the degree wherein the band gap is narrowed, for example in the case of $\alpha$-$Al_2O_3$ (corundum), Al is vapor-deposited on the cleaned (0001) face of Ru, oxidized to form $\gamma$-$Al_2O_3$, and phase transition of the $\gamma$-$Al_2O_3$ forms $\alpha$-$Al_2O_3$.

The methods of forming an ultra-thin metal film include vapor deposition, the CVD method and the PVD method.

Furthermore, according to the present invention, ultra-thin metal films can be multilayered. It is estimated that the electrical and metallurgical properties of the multilayer film are totally different from the electrical and metallurgical properties of a conventional thin film formed by aggregating clusters, even if they have the same thickness.

A metal layer can be formed in an island shape using the technique of the present invention. In this case, the surface area of the metal layer, relative to the quantity of the metal which is used, increases so as to be suitable for use as catalysts and the like.

Brief Description of the Drawings

Figure I is a sectional view of a state wherein an ultra-thin metal film according to the present invention is formed on a conductive base material;
Figure 2 is a schematic drawing similar to Figure 1 showing another example;
Figure 3 is a schematic drawing similar to Figure 1 showing another example;
Figure 4 is a photograph showing a low energy electron diffraction (LEED) pattern of $\alpha$-$Al_2O_3$ on Ru (0001) (annealing temperature: 1050°C);
Figure 5 is a photograph showing a low energy electron diffraction (LEED) pattern of $\gamma$-$Al_2O_3$ on Ru (0001) (annealing temperature: 960°C);
Figures 6 (a) and (b) are photographs showing images by a scanning tunneling microscope (STM); (a) is a photograph showing an image when the bias voltage is - 70 meV, and (b) is a photograph showing an image when the bias voltage is +70 meV;
Figure 7 is a scanning tunneling microscope (STM) image of an ultra-thin metal film according to the present invention;
Figure 8 is an I-V curve of an ultra-thin metal film according to the present invention;
Figure 9 is a scanning tunneling microscope (STM) image showing a state wherein metal atoms aggregate to form a cluster;
Figure 10 is an I-V curve of a peripheral portion of a state wherein a cluster is formed;
Figure 11 is an infrared absorption spectrum of CO adsorbed on an ultra-thin Pt film (monatomic film) for $\alpha$-$Al_2O_3$;
Figure 12 is an infrared absorption spectrum of CO adsorbed on an ultra-thin Pt film (5-atomic film) for $SiO_2$;
Figure 13 (a) is an infrared absorption spectrum of CO on Pt (111), and Figure 13 (b) is an infrared absorption spectrum of CO on Pt (111)-Ge; and
Figure 14 is a schematic drawing for illustrating the bridge site and on-top site of CO.

Best Mode for Carrying Out the Invention

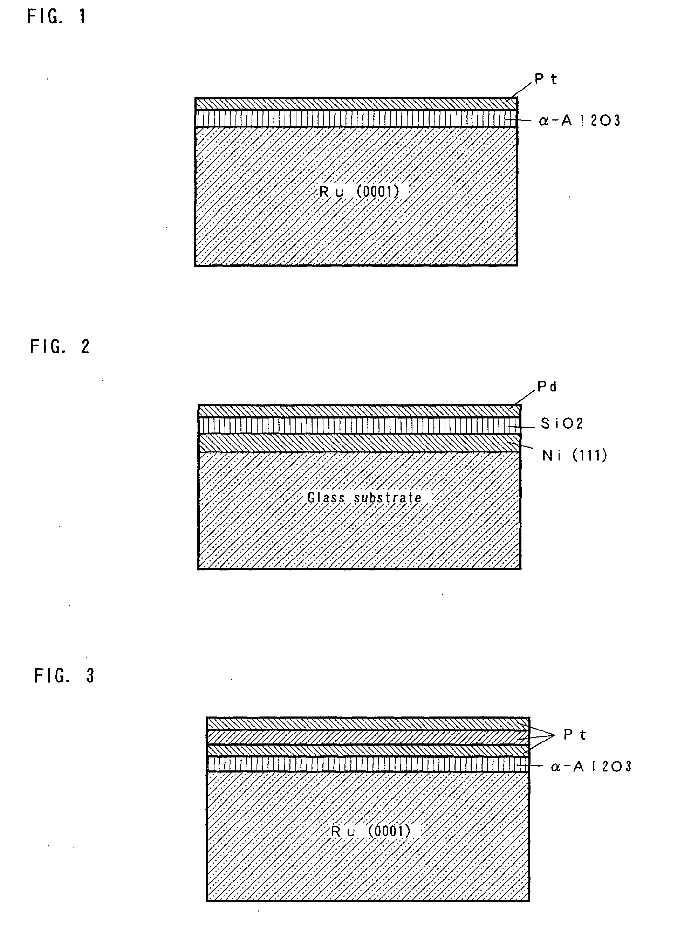

As shown in Figure 1, $\alpha$-$Al_2O_3$ (corundum) of a thickness of 1 nm is formed on the (0001) crystal face of an Ru substrate, and the ultra-thin film (monatomic film) of Pt of a thickness of about 0.2 nm (2 angstroms) is formed on the thin $\alpha$-$Al_2O_3$ film.

Figures 2 and 3 show other examples, and in the example shown in Figure 2, an Ni single-crystal layer is formed as a conductive base material on a glass substrate, an $SiO_2$ ($\beta$-quartz) of a thickness of 1 nm is formed on the (111) crystal face of the Ni, and an ultrathin film (monatomic film) of Pd of a thickness of about 0.2 nm (2 angstroms) is formed on the thin $SiO_2$ film. In the example shown in Figure 3, an ultra-thin film (monatomic film) of Pt is multilayered (layer-by-layer growth) on the $\alpha$-$Al_2O_3$ (corundum).

Next, an example of specific fabricating conditions will be described. First, the conditions for forming $\alpha$-$Al_2O_3$ (corundum) of a thickness of 3.5 nm or less on the (0001) crystal face of an Ru substrate are as follows:

A thin single-crystal $\alpha$-$Al_2O_3$ film was obtained by the phase transition of an amorphous oxide formed on the Ru (0001) face. The Ru (0001) face is a nice candidate as the metal substrate. This is because lattice mismatch between $\alpha$-$Al_2O_3$ and Ru (0001) is small, and the melting point of Ru is sufficiently higher than the phase transition temperature of $Al_2O_3$ from the $\gamma$-phase to the $\alpha$-phase. The phase transition temperature from $\gamma$-$Al_2O_3$ formed as an oxide to $\alpha$-$Al_2O_3$ is about 1,000°C.

An Ru sample of an Ru single-crystal disc was obtained by cutting from a single-crystal rod (6 mm in diameter), whose crystal orientation had been determined by X-ray diffraction, with a diamond-coated wire, and polishing with a water-born alumina powder having a particle diameter of 0.05 μm. Grooves having a width of 0.3 mm were formed in parallel to the surface on the upper and lower sides of the disc. Short W (tungsten) wires of a diameter of 0.3 mm were inserted into the grooves to set the Ru sample to a sample holder made of tantalum. Heating was performed by passing electric current through the W wires, and the temperature of the Ru sample was measured by a Pt-Pt (Rh) thermocouple attached to the side of the sample, as well as by an optical pyrometer.

The cleaning of the Ru (0001 ) face was performed by repetition of heating to 950°C in an oxygen atmosphere (about $3 \times 10^{-5}$ Pa) and heating to 1,100°C in vacuum, until the carbon signal with Auger electron spectroscopy disappeared completely. The low-energy electron diffraction (LEED) pattern showed a clear hexagonal symmetry.

After the clear surface was obtained, Al was vapor-deposited on the Ru surface at 400°C, and completely oxidized by gradually elevating the temperature to 1,050°C in an oxygen atmosphere of $2 \times 10^{-4}$ Pa.

Since complete oxidation is difficult if the vapor-deposited thickness of Al is thicker than 1 nm, it is stopped to be thinner than 1 nm.

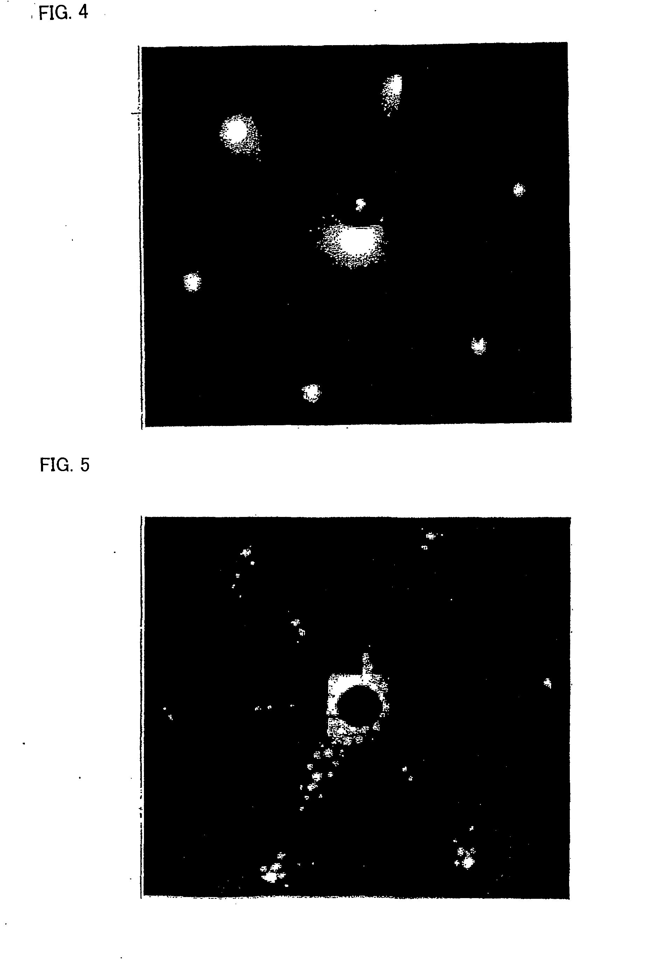

When metallic Al is not detected by Auger electron spectroscopy, phase transition from $\gamma$-$Al_2O_3$ to $\alpha$-$Al_2O_3$ is performed. After annealing at 1,050°C for 20 minutes in an oxygen atmosphere of $2 \times 10^{-4}$ Pa, a clear $1 \times 1$ LEED pattern shown in Figure 4 was observed. From this $1 \times 1$ LEED pattern, the $Al_2O_3$ on Ru (0001) can be determined to be $\alpha$-$Al_2O_3$.

When Al is deposited in a thickness of 1 nm, it is estimated from the signal of Auger electrons that the thickness of the $\alpha$-$Al_2O_3$ is about 0.9 nm. If annealing temperature is a little lower than the phase-transition temperature (for example, the annealing temperature is 960°C), a very complicated LEED pattern as shown in Figure 5 is observed.

The maximum film thickness of the single-crystal oxide film formed in one time is about 0.9 nm. A sample oxide having a thickness of about 3 nm is obtained by repetition of vapor deposition, oxidation and phase transition due to annealing.

On the other hand, conditions for forming an ultra-thin Pt film on $\alpha$-$Al_2O_3$ (corundum) are as follows:

A Pt wire having a diameter of 0.3 mm wound around a 0.5-mm W (tungsten) wire was used as a Pt source. The ultra-thin Pt film was obtained by heating the W wire. The thickness of Pt was determined by the Pt vapor pressure and the deposition time. The temperature was measured using an optical pyrometer.

The structure of the ultra-thin Pt (platinum) film was verified with images obtained using an Omicron UHV-STM apparatus, and the I-V (current-voltage) curve observed by scanning tunneling spectroscopy (STS).

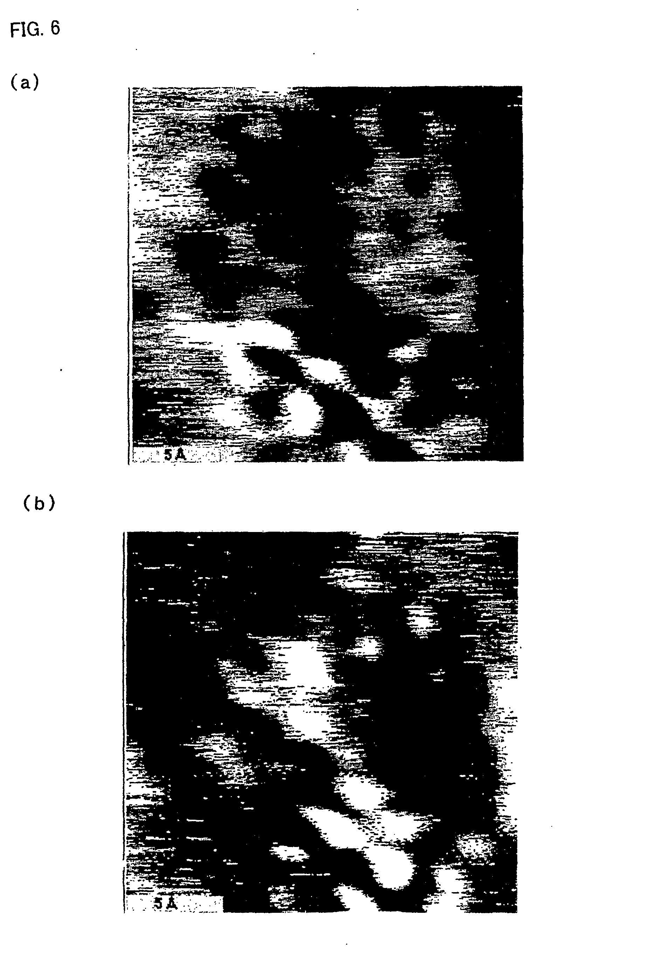

Auger electron spectroscopy is generally used for the determination of the thickness for ultra-thin films. However, since the Pt signal of Auger electrons overlaps with the signal of $Al^{3+}$ at 55 eV, Auger electron spectroscopy was not used. Figures 6 (a) and 6(b) show the images of a scanning tunneling microscope obtained with bias voltages of -70 mV and +70 mv, respectively, and ultra-thin Pt films show the structure of a monatomic layer having irregular atomic arrangement.

These agree with the diffraction patterns obtained by low-energy electron diffraction (LEED). The regular structure of the ultra-thin Pt film formed on the $\alpha$-$Al_2O_3$/Ru (0001) face was not observed by low-energy electron diffraction (LEED).

Corrugation corresponding to atomic images is 0.1 nm or less. Circular shapes seen in Figures 6 (a) and 6 (b) are considered to be Pt atoms. Images of light portions and dark portions corresponding to atomic shapes by a scanning tunneling microscope are clearly shown. Both light portions and dark portions are atoms.

By reversing the polarity of the applied bias voltage, the light portions and dark portions are reversed. Atoms shown as light portions at -70 meV are shown as dark portions at +70 meV. Atoms shown as dark portions at -70 meV are shown as light portions at +70 meV. That is, the voltage reversal reverses light and dark portions. This suggests that charge density waves are present in the ultra-thin Pt film.

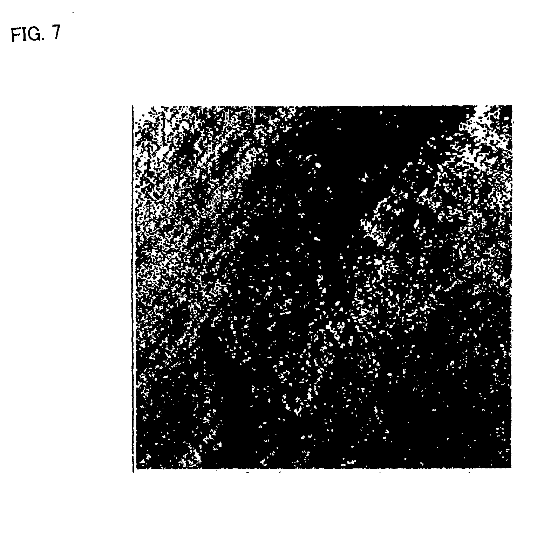

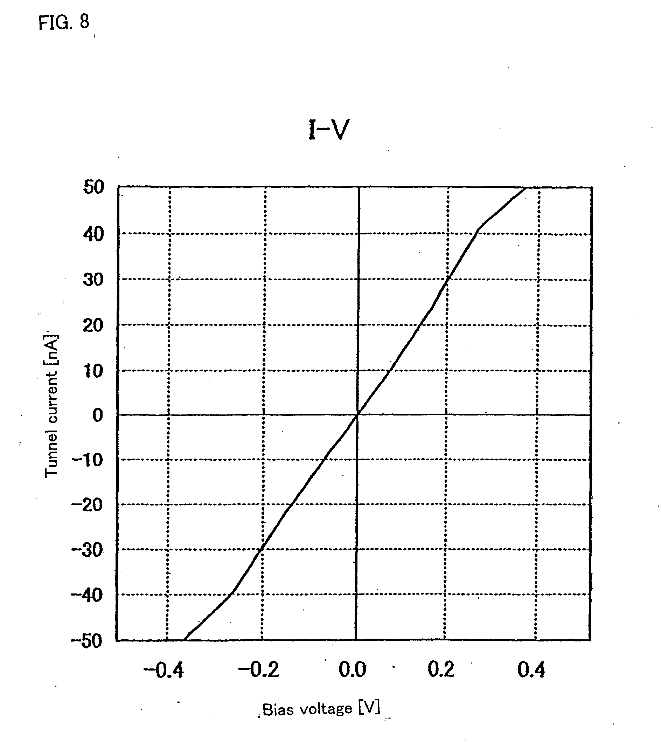

Figure 7 is a scanning tunneling microscope (STM) image of an ultra-thin metal film according to the present invention; and Figure 8 is an I-V curve of an ultra-thin metal film according to the present invention. As shown in Figure 7, no clusters are formed in the ultra-thin metal film according to the present invention. As shown in Figure 8, the I-V (current-voltage) curve observed by scanning tunneling spectroscopy (STS) shows metallic characteristics. In Figure 8, the average of 100 curves measured at different points within the area of $50 \times 50$ nm$^2$ is shown. The deviation of the 100 curves was extremely small.

The observation was carried out within the bias-voltage range of -0.4 V to 0.4 V. At the same point (same voltage), the I-V (current-voltage) curve did not change even after repeated measurements of scanning tunneling spectroscopy (STS).

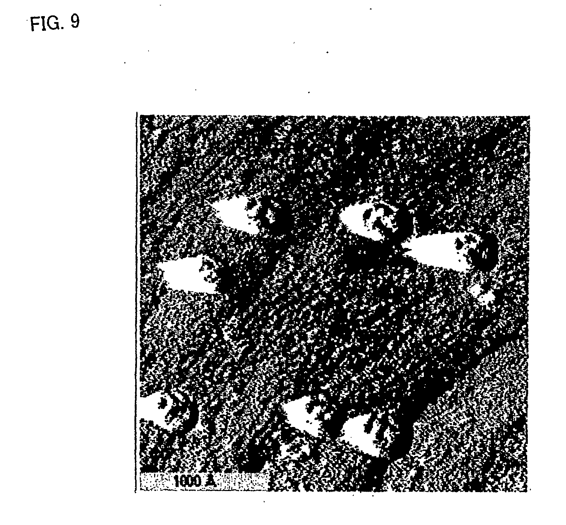

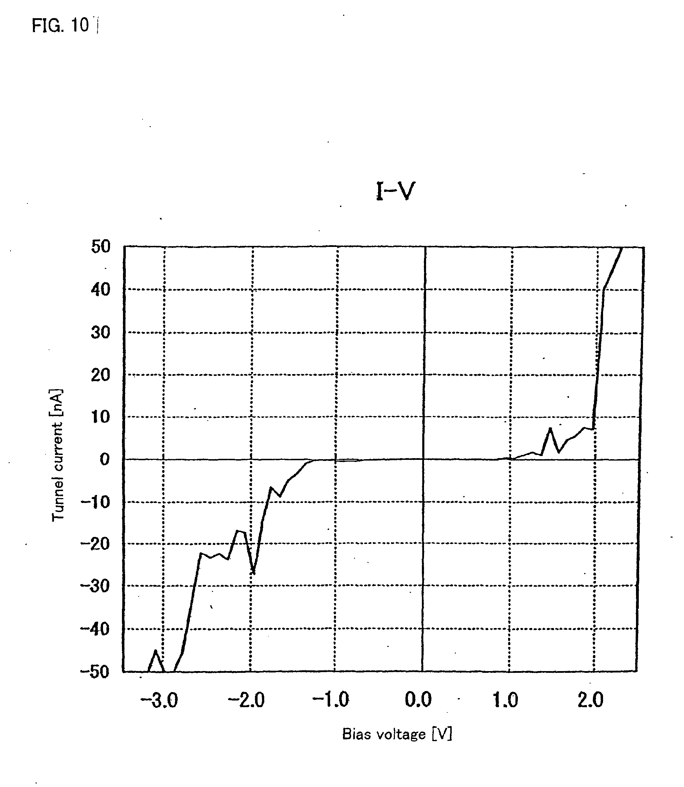

However, when the bias voltage was scanned from -5 V to 5 V, a dramatic change occurred in the I-V curve. After the bias voltage was scanned 5 times from - 5 V to 5 V, the scanning tunneling microscope (STM) image is shown in Figure 9, and the I-V curve in the vicinity of a Pt cluster is shown in Figure 10. As shown in Figure 9, a Pt cluster appears when a strong electric field is applied. The Pt cluster was about 30 nm in diameter and 6 to 8 nm in thickness. Namely, a large number of Pt atoms are migrated and aggregated by a strong electric field to form a Pt cluster. As a result, as seen in Figure 10, an insulating region appears around the Pt cluster.

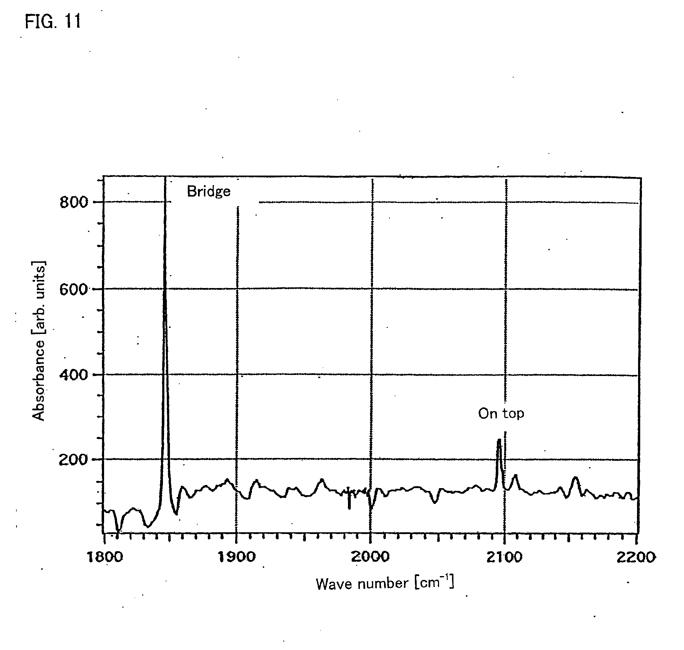

In order to examine the metallurgical characteristics of the ultra-thin Pt film formed on the $\alpha$-Al$_2$O$_3$/Ru (0001) face, the infrared absorption spectrum by reflection method (RAIRS) of adsorbed CO was measured. The result is shown in Figure 11.

The infrared absorption spectrum was obtained by a Fourier transform infrared absorption spectrometer. In the present invention, the vibrational spectrum of CO is effective to the ultra-thin Pt film formed on the $\alpha$-Al$_2$O$_3$/Ru (0001) face, and CO was adsorbed and the spectrum was measured at 80K.

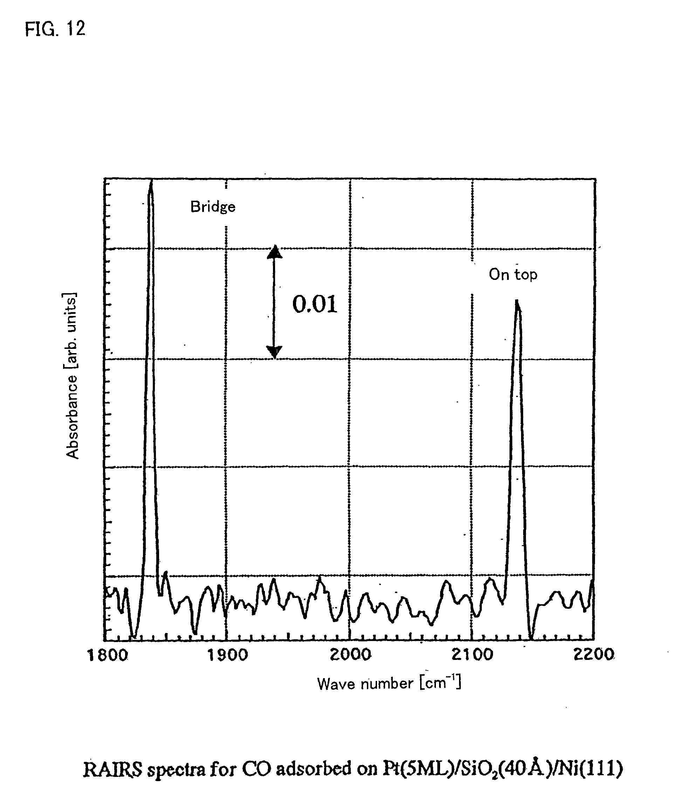

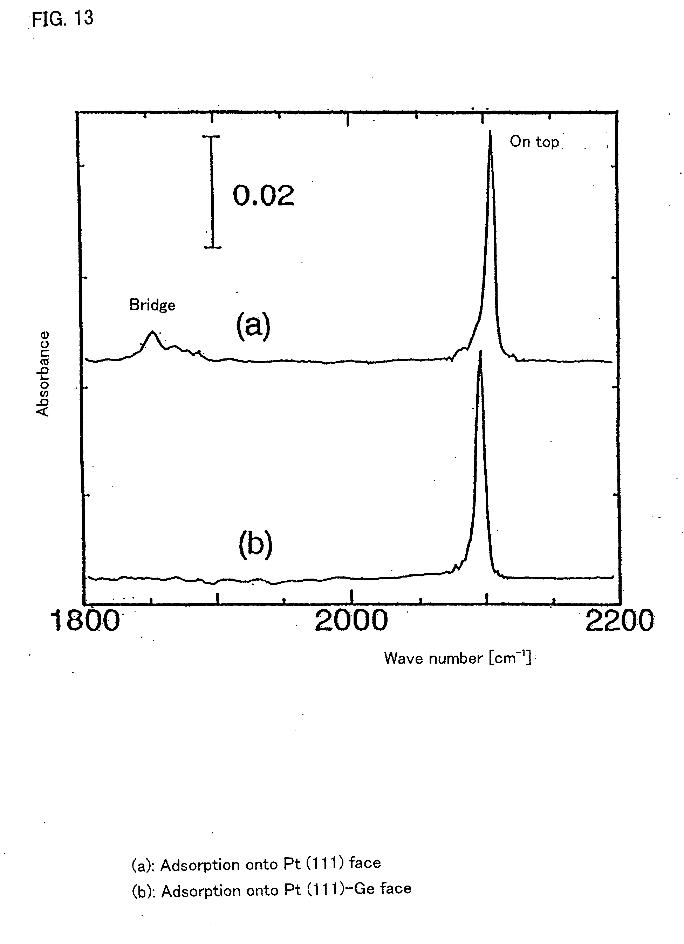

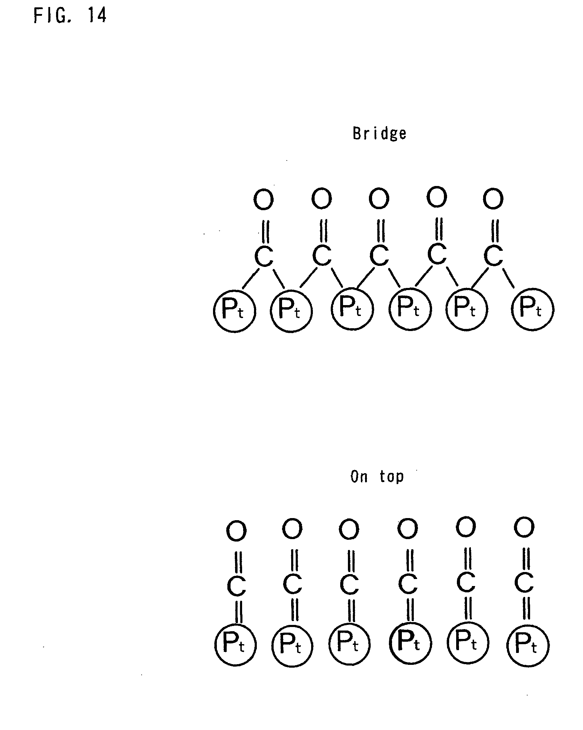

Next, the bridge and the on top as the adsorption site of CO will be described based on Figures 11 to 14. Here, Figure 11 is an infrared absorption spectrum of CO on an ultra-thin Pt film (monatomic film) for an $\alpha$-Al$_2$O$_3$ substrate; Figure 12 is an infrared absorption spectrum of CO on an ultra-thin Pt film (5-atomic film) for SiO$_2$ substrate; Figure 13 (a) is an infrared absorption spectrum of CO on Pt (111); Figure 13 (b) is an infrared absorption spectrum of CO on Pt (111 )-Ge face alloy; and Figure 14 is a diagram for illustrating the bridge site and the on-top site of CO. The CO adsorption site on the Pt surface observed by reflection absorption infrared spectrum (PAIRS) is significantly different from the CO adsorption site on the Pt (111) face and the Pt (111)-Ge face alloy. In the normal case, that is Pt (111), a large number of CO adsorption sites are on-top sites, and the CO adsorption on the Pt (111)-Ge face alloy is only on-top sites. Whereas in the ultra-thin Pt film CO adsorbed on the bridge sites is the predominant species.

It is considered that the phenomenon of the CO adsorption sites in this example is caused by the electronic properties. According to observation by scanning tunneling microscope (STM) and low-energy electron diffraction (LEED), since the Pt-Pt distances are random, if the adsorption site is considered to be caused by a geometric origin, the structure of the bridge site is considered undesirable. From two causes of the symmetry of the d-orbital and the interaction of the d-orbitals of Pt and Ru, in the Pt monatomic film, the bridge site is considered to be more stable than the on-top site.

For a face-centered cubic Pt atom, five d-orbitals in an $O_h$ point group is divided into an $e_g(d_{x2-y2}$ and $d_{3z2-r2})$ orbital and a $t_{2g}(d_{xy},\ d_{yz}$ and $d_{zx})$ orbital, where x, y and z are coordinates parallel to the elementary lattice vector of a cubic lattice.

On the other hand, in the $D_{3d}$ point group in a monatomic layer of a Pt atom, the $t_{2g}$ orbital in an $O_h$ point group is divided into an $e_g(d_{yz}$ and $d_{zx})$ and an $a_{1g}$ $(d_{xy})$ orbital, and the $e_g(d_{x2-y2}$ and $d_{3z2-r2})$ orbital does not change.

Five d-orbitals in the $D_{3d}$ point group are divided into two $e_g$ orbitals and one $a_{1g}$ orbital, and the two eg orbitals are mixed because they have the same symmetry. When the atom arrangement of bonding adsorbed on the Pt (111) face is examined, new axes, x', y' and z' must be taken in the three directions of [11 ,2], [1 ,10] and [111], respectively.

The $\sigma$-bonding of the bridge site in CO adsorption is formed by the $d_{y'z'}$ orbital in the y'-z' (or z'-x') face. This is represented by $(2\ d_{x2-y2} - d_{yz} + d_{zx})/\sqrt{6}$. Thus, the contribution of the eg orbital to the $\sigma$-bonding becomes dominant, and on the other hand, the $\sigma$-bonding of the on-top site is affected by the $t_{2g}$ orbital. However, in the case of a $D_{3d}$ point group, CO adsorption on the bridge site is affected by the eg orbital (for example, $d_{x2-y2}$, $d_{yz}$ and $d_{zx}$). Therefore, the bridge site is considered to be the predominant adsorption site of CO.

As also shown in Figure 11, the predominant adsorption site of CO to a Pt monatomic film is the bridge site. In this case, it is considered that the d-hole density of Pt increases due to the interaction with the d-band of Ru in the substrate, holes are formed in the $e_g$ orbital, and the bridge site becomes the predominant adsorption site. Therefore, increase in the d-hole density suggests the possibility to promotet a catalytic activity that a metal other than Pt can substitute Pt.

Here, a Pt catalyst has extremely high oxidation ability in the reaction of CO and H$_2$ similar to Pd and the like, and is widely used as the exhaust-gas purifying catalyst (three-way catalyst) for motor vehicles. Although a Pt catalyst is used as a catalyst for fuel cells, when the quantity of CO adsorbed on the surface of the Pt catalyst increases, the catalytic activity is reduced and the life is shortened.

As also shown in Figure 12, the on-top site appears significantly in the 5-atom multilayered film of Pt. However, the wave number of the absorption of the on-top site is about 40 cm$^{-1}$ larger than the wave number of CO adsorbed on bulk Pt, or the case of Figure 11. This shows that the density of d-holes increases, the electron transfer from Pt to the $\pi^*$orbital of CO decreases, the bonding of CO to Pt is weakened, and CO is easily removed. As a result, it is considered that the 5-atom multilayered film of Pt is protected from being poisoned due to CO compared with bulk Pt, and the life of the catalyst of fuel cells can be extended

Industrial Application

According to the present invention, an ultra-thin metal film or a film wherein ultra-thin metal films are multilayered can be obtained without forming clusters. Therefore, the thickness of Pt, Pd and the like, used as the catalyst for fuel cells, the catalyst for cleaning exhaust gas and the like, can be reduced to 1 /10 or less than in conventional methods; and the life as the catalyst can be extended, resulting in significant cost reduction.

In addition, since a continuous ultra-thin metal film can be obtained, the thickness of the gate electrode composing an integrated circuit can be made thin to several nanometers, the density of the integrated circuit can further be elevated. Application to the magnetic head or the like of a hard-disk drive can also be considered.

Furthermore, the present invention is based on extremely interesting findings, and the uses thereof are not limited to catalysts or semiconductor devices, but applications to every use can be considered.

**Claims**

1. An ultra-thin metal film **characterized in that** the ultra-thin metal film is formed on the surface of a conductive base material that exhibits metallic conduction through a thin dielectric film.

2. The ultra-thin metal film according to claim 1, **characterized in that** said ultra-thin metal film is formed on the surface of a metallic base material through a thin dielectric single-crystal film.

3. The ultra-thin metal film according to claim 1, **characterized in that** the film thickness of said thin dielectric film causes the significant tunneling effect between metals through said thin dielectric film, or a film thickness whereby the valence electrons and holes of the metal composing the conductive base material and the ultra-thin metal film are affected by the many-body effects.

4. The ultra-thin metal film according to claim 1, **characterized in that** the band-gap width of said thin dielectric film is narrower than the band-gap width in the normal state.

5. The ultra-thin metal film according to claim 3 or claim 4, **characterized in that** the film thickness of said thin dielectric film is 5 nm or less.

6. The ultra-thin metal film according to any of claim 3 to claim 5, **characterized in that** the conductive base material whereon said thin dielectric film is formed is composed of a single-crystal metal whose lattice constant is close to the lattice constant of said dielectric.

7. The ultra-thin metal film according to any of claim 3 to claim 6, **characterized in that** the metal that composes the ultra-thin metal film is any of metals such as Pt (platinum), Pd (palladium), Ni (nickel), Ti (titanium), Au (gold), Ag (silver), Cu (copper), Al (aluminum), Zn (zinc), Co (cobalt), Mn (manganese), Mo (molybdenum), W (tungsten), Re (rhenium), Ru (ruthenium) and Rh (rhodium); or a Pt-Ru system, a Pt-Pd system, a Pt-Rh system, a Pt-Ni system, a Pt-Cr system, a Pt-Co system, a Pt-Mo system, a Pt-Fe system, an Ni-Mo system, an Ni-Co system, an Ni-Mo-Co system, an Mo-Co system, an Fe-Cr system, a Cu-Zn system, a Cu-Cr system, a Cu-Ni system, a Zn-Cr system, a Zn-Al system, a Cd-Cu system and Cd-Zn.

8. The ultra-thin metal film according to any of claim 1 to claim 6, **characterized in that** said thin dielectric film is any of $Al_2O_3$, $SiO_2$, MgO and AlN.

9. The ultra-thin metal film according to any of claim 1 to claim 6, **characterized in that** the band gap in the normal state of said thin dielectric film is 5 eV or more.

10. The ultra-thin metal film according to any of claim 1 to claim 6, **characterized in that** said dielectric base material is any of Ru (ruthenium), Ni (nickel), Mo (molybdenum), Ta (tantalum), Ag (silver), Co (cobalt) and graphite.

11. The ultra-thin metal film according to claim 10, **characterized in that** said dielectric base material is formed on the surface of the other metal, silicon, ceramics or glass by epitaxial growth.

12. An ultra-thin metal multilayer film comprising ultra-thin metal films composed of single metal atoms consisting of two-dimensionally continuous multilayer, **characterized in that** said ultra-thin metal multilayer film is formed on the surface of a conductive base material that exhibits metallic conduction through a thin dielectric film.

13. The ultra-thin metal multilayer film according to claim 12, **characterized in that** said ultra-thin metal multilayer film is formed on the surface of the conductive base material through a single-crystal film of the dielectric.

14. The ultra-thin metal multilayer film according to claim 12, **characterized in that** the film thickness of said thin dielectric film causes the significant tunneling effect between metals through said thin dielectric film, or a film thickness whereby the valence electrons and holes of the metal composing the conductive base material and the ultra-thin metal film are affected by the many-body effects.

15. The ultra-thin metal multilayer film according to claim 12, **characterized in that** the ultra-thin metal film at the interface composing said ultra-thin metal multilayer film is formed on the single-crystal film of the dielectric whose band-gap width has become narrower than the band-gap width in the normal state.

16. The ultra-thin metal multilayer film according to claim 14 or claim 15, **characterized in that** the film thickness of said thin dielectric film is 5 nm or less.

17. The ultra-thin metal multilayer film according to any of claim 14 to claim 16, **characterized in that** the conductive base material whereon said thin dielectric film is formed is composed of a single-crystal metal whose lattice constant is close to the lattice constant of said dielectric.

18. The ultra-thin metal multilayer film according to any of claim 12 to claim 17, **characterized in that** the metal that composes the ultra-thin metal film is any of metals such as Pt (platinum), Pd (palladium), Ni (nickel), Ti (titanium), Au (gold), Ag (silver), Cu (copper), Al (aluminum), Zn (zinc), Co (cobalt), Mn (manganese), Mo (molybdenum), W (tungsten), Re (rhenium), Ru (ruthenium) and Rh (rhodium); or a Pt-Ru system, a Pt-Pd system, a Pt-Rh system, a Pt-Ni system, a Pt-Cr system, a Pt-Co system, a Pt-Mo system, a Pt-Fe system, an Ni-Mo system, an Ni-Co system, an Ni-Mo-Co system, an Mo-Co system, an Fe-Cr system, a Cu-Zn system, a Cu-Cr system, a Cu-Ni system, a Zn-Cr system, a Zn-Al system, a Cd-Cu system and Cd-Zn system.

19. The ultra-thin metal multilayer film according to any of claim 12 to claim 17, **characterized in that** said thin dielectric film is any of $Al_2O_3$, $SiO_2$, MgO and AlN.

20. The ultra-thin metal multilayer film according to any of claim 12 to claim 17, **characterized in that** the band gap of said thin dielectric film in the normal state is 5 eV or more.

21. The ultra-thin metal multilayer film according to any of claim 12 to claim 17, **characterized in that** said dielectric base material is any of Ru (ruthenium), Ni (nickel), Mo (molybdenum), Ta (tantalum), Ag (silver), Co (cobalt) and graphite.

22. The ultra-thin metal multilayer film according to claim 21, **characterized in that** said dielectric base material is formed on the surface of the other metal, silicon, ceramics or glass by epitaxial growth.

23. A method of fabricating an ultra-thin metal film or an ultra-thin metal multilayer film, **characterized in that** a thin dielectric film is formed on a conductive base material that exhibits metallic conduction in a film thickness that causes the significant tunneling effect between metals through said thin dielectric film, or a film thickness whereby the valence electrons and holes of the metal composing the conductive base material and the ultra-thin metal film are affected by the many-body effects; and the ultra-thin metal films are grown in layer-by-layer on said thin dielectric film by the deposition method.

24. A method of fabricating an ultra-thin metal film or an ultra-thin metal multilayer film, **characterized in that** a dielectric single-crystal film is formed on the surface of a metallic base material through a thin dielectric single-crystal film having a film thickness that causes the significant tunneling effect between metals through said thin dielectric single-crystal film, or a film thickness whereby the valence electrons and holes of the metal composing the metallic base material and the ultra-thin metal film are affected by the many-body effects; and the ultra-thin metal films are grown in layer-by-layer on said thin dielectric single-crystal film by the deposition method.

25. A method of fabricating an ultra-thin metal film or an ultra-thin metal multilayer film, **characterized in that** a thin dielectric film is formed on a conductive base material that exhibits metallic conduction in a film thickness wherein the band-gap width of said dielectric is narrowed; and the ultra-thin metal films are grown in layer-by-layer on said thin dielectric film by the deposition method.

26. A method of fabricating an ultra-thin metal film or an ultra-thin metal multilayer film, **characterized in that** a thin dielectric single-crystal film is formed on a metallic base material in a film thickness wherein the band-gap width of said dielectric is narrowed; and the ultra-thin metal films are grown in layer-by-layer on said thin dielectric single-crystal film by the deposition method

27. The method of fabricating an ultra-thin metal film or an ultra-thin metal multilayer film according to claim 23 to claim 26, **characterized in that** said thin dielectric film is fabricated under the following conditions:

> (1) Orientation is performed so that the surface of the conductive base material whereon a thin dielectric film is formed becomes a predetermined crystal face.
> (2) The surface on which a thin dielectric film is formed is cleaned.
> (3) A metal that composes the dielectric is vapor-deposited, and oxidized by heating in an oxygen atmosphere.
> (4) A heat-treatment is performed to cause the phase transition of the dielectric film to a single-crystal film or an oriented polycrystalline film.

28. The method of fabricating an ultra-thin metal film or an ultra-thin metal multilayer film according to claim 23 to/or claim 26, **characterized in that** said ultra-thin metal film is fabricated by vapor deposition, CVD or PVD.

FIG. 1

Pt
α-Al2O3
Ru (0001)

FIG. 2

Pd
SiO2
Ni (111)
Glass substrate

FIG. 3

Pt
α-Al2O3
Ru (0001)

FIG. 4

FIG. 5

FIG. 6

(a)

(b)

FIG. 7

FIG. 8

I-V

FIG. 9

FIG. 10

I-V

FIG. 11

FIG. 12

RAIRS spectra for CO adsorbed on Pt(5ML)/SiO₂(40Å)/Ni(111)

FIG. 13

(a): Adsorption onto Pt (111) face

(b): Adsorption onto Pt (111)−Ge face

FIG. 14

Bridge

On top

## INTERNATIONAL SEARCH REPORT

| International application No. |
|---|
| PCT/JP02/02490 |

| A. CLASSIFICATION OF SUBJECT MATTER |
|---|
| Int.Cl$^7$ C30B29/02 |

According to International Patent Classification (IPC) or to both national classification and IPC

| B. FIELDS SEARCHED |
|---|
| Minimum documentation searched (classification system followed by classification symbols) |
| Int.Cl$^7$ C30B1/00-35/00, C23C14/14, C23C16/16, H01L21/316 |

Documentation searched other than minimum documentation to the extent that such documents are included in the fields searched

| | | | |
|---|---|---|---|
| Jitsuyo Shinan Koho | 1926–1996 | Toroku Jitsuyo Shinan Koho | 1994–2002 |
| Kokai Jitsuyo Shinan Koho | 1971–2002 | Jitsuyo Shinan Toroku Koho | 1996–2002 |

Electronic data base consulted during the international search (name of data base and, where practicable, search terms used)
CAS ONLINE, WPI, JICST FILE

| C. DOCUMENTS CONSIDERED TO BE RELEVANT | | |
|---|---|---|
| Category* | Citation of document, with indication, where appropriate, of the relevant passages | Relevant to claim No. |
| X | Martin FRANK et al., Vibrational spectroscopy of CO adsorbed on supported ultra-small transition metal particles and single metal atoms. Surface Science, 20 May, 2000 (20.05.00), Vols.454 to 456, pages 968 to 973; page 969, left column lines 17 to 35 | 1–28 |
| X | T.T. MAGKOEV et al., Ni Adatoms on Al$_2$O$_3$ Film Probed by NO Adsorption: a RAIRS Study. Physica Status Solidi B, 8 January, 2001 (08.01.01), Vol.223, No.2, pages 3 to 5; page 3, line 17 to page 4, line 16 | 1–28 |
| A | JP 2000-211998 A (Gijutsu Kenkyu Kumiai Angstrome Technology Kenkyu Kiko and another), 02 August, 2000 (02.08.00), (Family: none) | 1–28 |

| ☒ Further documents are listed in the continuation of Box C. | ☐ See patent family annex. |
|---|---|

| * Special categories of cited documents: | |
|---|---|
| "A" document defining the general state of the art which is not considered to be of particular relevance | "T" later document published after the international filing date or priority date and not in conflict with the application but cited to understand the principle or theory underlying the invention |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 09 April, 2002 (09.04.02) | 23 April, 2002 (23.04.02) |

| Name and mailing address of the ISA/ | Authorized officer |
|---|---|
| Japanese Patent Office | |
| Facsimile No. | Telephone No. |

Form PCT/ISA/210 (second sheet) (July 1998)

**EP 1 375 691 A1**

## INTERNATIONAL SEARCH REPORT

| International application No. |
|---|
| PCT/JP02/02490 |

| C (Continuation). DOCUMENTS CONSIDERED TO BE RELEVANT | | |
|---|---|---|
| Category* | Citation of document, with indication, where appropriate, of the relevant passages | Relevant to claim No. |
| A | B.G. FREDERICK et al., Electronic and vibrational properties of hydroxylated and dehydroxylated thin $Al_2O_3$ films. Surface Science, March 1991, Vol.244, No.1/2, pages 67 to 80 | 1-28 |

Form PCT/ISA/210 (continuation of second sheet) (July 1998)

20